# EUROPÄISCHE PATENTSCHRIFT

(11) **EP 0 469 307 B1**
(45) Veröffentlichungstag und Bekanntmachung des Hinweises auf die Patenterteilung: **08.01.1997**
(21) Anmeldenummer: 91110825.6
(22) Anmeldetag: 29.06.1991
(51) Int. Cl.: G03F 7/11

(54) **Photopolymerisierbare Druckplatte für Flexodruck**
Photopolymerizable printing plate for flexographic printing
Cliché photopolymérisable pour l'impression flexographique

(30) Priorität: 19.07.1990 DE 4022979
(43) Veröffentlichungstag der Anmeldung: 05.02.1992
(73) Patentinhaber: DU PONT DE NEMOURS (DEUTSCHLAND) GMBH, 61352 Bad Homburg (DE); E.I. DU PONT DE NEMOURS AND COMPANY, Wilmington Delaware 19898 (US)
(72) Erfinder: Abele, Werner, Dr., W-6078 Neu-Isenburg (DE)
(74) Vertreter: Patentanwälte Lippert, Stachow, Schmidt & Partner

(56) Entgegenhaltungen:
- WORLD PATENTS ABSTRACTS, Woche 9012, 2. Mai 1990, Nr. 90-086671/12, Derwent Publications Ltd.; & JP-A-2 039 048

## Beschreibung

Die Erfindung betrifft photopolymerisierbare Druckplatten, deren wesentliche Bestandteile eine photopolymerisierbare Schicht und eine auf dieser Schicht aufgebrachte elastomere Schicht, enthaltend mindestens ein thermoplastisch elastomeres Blockcopolymer und mindestens ein Umsetzungsprodukt eines Epoxidharzes mit einem teilweise mit Polyolen veresterten Addukt von ungesättigten Mono- und/oder Polycarbonsäuren oder deren Anhydriden mit Kolophoniumharzen, sind. Aus diesen Materialien hergestellte Druckformen für den Flexodruck weisen ein verbessertes Druckverhalten besonders mit alkoholischen und wäßrigen Druckfarben auf.

Es ist bekannt, für die Herstellung von Druckformen für den Flexodruck photopolymerisierbare Aufzeichnungsmaterialien zu verwenden, bei denen die Druckoberfläche durch bildmäßiges Belichten einer lichtempfindlichen Schicht und anschließendes Entfernen der unbelichteten Schichtteile erzeugt wird. Hierbei kann man zwischen festen, photopolymerisierbaren Materialien und solchen, bei denen die bildmäßige Belichtung an flüssigen Systemen durchgeführt wird, unterscheiden. Außerdem gibt es sowohl wäßrig entwickelbare als auch mit organischen Lösungsmitteln entwickelbare, photopolymerisierbare Aufzeichnungsmaterialien.

In der US 4,238,560 werden z.B. wäßrig entwickelbare Druckplatten bestehend aus einem Schichtträger, einer photoempfindlichen Schicht und einer Mattierungsschicht beschrieben. Bei der Entwicklung mit wäßrigen Lösungen wird neben den Nichtbildteilen der photoempfindlichen Schicht auch die gesamte Mattierungsschicht entfernt. Diese enthält neben dem eigentlichen Mattierungsmittel noch Kolophonium oder Kolophoniumester, die , wie aus Ullmanns Encyclopädie der technischen Chemie, 4. Auflage, Band 12, S. 530 - 536, Verlag Chemie, Weinheim 1976 zu entnehmen ist, aufgrund ihrer hohen Pigmentverträglichkeit auch in Lacken und Druckfarben verwendet werden.

Ein besonderer Nachteil der wäßrig entwickelbaren Druckplatten gegenüber lösungsmittelentwickelbaren Materialien ist ihre geringe Beständigkeit in alkoholischen und wäßrigen Druckfarben, wodurch Quellungen der Druckoberfläche und damit fehlerhafte Druckergebnisse hervorgerufen werden.

Beispiele für feste, lösungsmittelentwickelbare Aufzeichnungsmaterialien finden sich in den folgenden Patentschriften: DE-C3 22 15 090; US-A 4,266,005; US-A 4,320,188 und US-A 4,430,417. Solche photopolymerisierbaren Druckplatten setzen sich üblicherweise aus einem Schichtträger, ggf. einer Haft-oder anderen Unterschicht, einer photopolymerisierbaren Schicht, die mindestens ein polymeres Bindemittel, mindestens ein durch aktinische Strahlung additionspolymerisierbares, ethylenisch ungesättigtes Monomer und einen Photoinitiator oder ein Photoinitiatorsystem enthält, und einem Deckelement, bestehend aus einem biegsamen Polymerfilm, der im Entwicklerlösungsmittel löslich ist, und einer abtrennbaren Deckfolie, zusammen.

Eine bevorzugte Methode zur Herstellung solcher mehrschichtigen, photopolymerisierbaren Druckplatten ist ein Verfahren, bei dem in den Spalt eines Kalanders eine vorher extrudierte, photopolymerisierbare Masse eingeführt und zwischen einen Träger und ein Deckelement kalandriert wird, wodurch eine photopolymerisierbare Schicht zwischen ihnen gebildet wird.

Aus der EP-B1 00 84 851 ist ein Herstellungsverfahren für eine mehrschichtige, photopolymerisierbare Druckplatte bekannt, die zwischen dem biegsamen Polymerfilm des Deckelements und der photopolymerisierbaren Schicht eine elastomere Schicht besitzt, die ein elastomeres Bindemittel, ggf. ein zweites Bindemittel, ggf. einen Farbstoff, ggf. ein oder mehrer Monomere und ggf. einen Photoinitiator enthält.

Häufig weisen jedoch die aus den beschriebenen mit Lösungsmitteln entwickelbaren Materialien hergestellten Flexodruckformen verschiedene Nachteile auf, von denen besonders die uneinheitliche Druckqualität zu erwähnen ist. So sind mit alkoholischen und wäßrigen Flexodruckfarben nur unbefriedigende Druckergebnisse zu erzielen, da in diesen Fällen eine unzureichende Farbübertragung beim Druck zu Farbfehlstellen führt. Besonders die Übertragung der 5%-Punkte ist bei der Verwendung solcher Druckfarben fehlerhaft.

Der vorliegenden Erfindung lag daher die Aufgabe zugrunde, dieses Druckproblem zu beseitigen und feste, photopolymerisierbare Druckplatten zur Verfügung zu stellen, mit denen Flexodruckformen mit verbesserter Farbübertragung hergestellt werden können. Desweiteren sollte die übliche Auswaschentwicklung mit organischen Lösungsmitteln möglich sein. Gleichzeitig sollten andere Eigenschaften der photopolymerisierbaren Druckplatten nicht negativ beeinflußt werden, z.B. sollte eine Verringerung der Photoempfindlichkeit vermieden werden. Außerdem sollten die Flexodruckformen in den Druckfarben nicht quellen, da dies zu einem unerwünschten Punktzuwachs und damit zu fehlerhaften Druckergebnissen führt.

Diese Aufgabe wurde überraschenderweise gelöst durch eine photopolymerisierbare Druckplatte im wesentlichen bestehend aus einem Schichtträger a), einer photopolymerisierbaren Schicht b), enthaltend mindestens ein elastomeres Bindemittel, mindestens ein durch aktinische Strahlung additionspolymerisierbares, ethylenisch ungesättigtes Monomer und einen Photoinitiator oder ein Photoinitiatorsystem, einer elastomeren Schicht c), enthaltend mindestens ein thermoplastisch elastomeres Blockcopolymer, und einer Deckfolie d).

Die Erfindung ist dadurch gekennzeichnet, daß die elastomere Schicht c) außerdem mindestens ein Umsetzungsprodukt eines Epoxidharzes mit einem teilweise mit Polyolen veresterten Addukt von ungesättigten Mono- und/oder Polycarbonsäuren oder deren Anhydriden mit Kolophoniumharzen enthält.

Überraschend war, daß die relativ polaren, erfindungswesentlichen Verbindungen mit den thermoplastisch elastomeren Blockcopolymeren der elastomeren Schicht c) ausreichend verträglich sind. Der Fachmann hätte erwartet, daß diese Verbindungen miteinander unverträglich sind oder zumindest nur eine begrenzte Verträglichkeit aufweisen und daß aufgrund dessen die erfindungsgemäßen Verbindungen beim Kalandrieren der verschiedenen Schichten der photopolymerisierbaren Druckplatte aufeinander aus der elastomeren Schicht ausschwitzen. Zudem war auch zu erwarten, daß sich die Schichten der Druckplatten bzw. -formen aufgrund der Unverträglichkeit der erfindungsgemäßen Verbindungen mit den übrigen Komponenten voneinander ablösen würden. Entgegen den Erwartungen weisen die neuen Flexodruckplatten und -formen jedoch eine hohe Stabilität und gleichmäßige Eigenschaften auf.

Desweiteren war es erstaunlich, daß die übliche Entwicklung mit organischen Lösungsmitteln ohne besondere Zusätze möglich ist, obwohl die erfindungswesentlichen Verbindungen ein ganz anderes Lösungsverhalten als die übrigen Komponenten der photopolymerisierbaren Druckplatte besitzen , wie der o.g. Einsatz strukturähnlicher Verbindungen in wäßrig entwickelbaren Materialien belegt. Auch ist überraschenderweise kein Auswaschen der erfindungswesentlichen Verbindungen und keine Quellung der erfindungsgemäß hergestellten Druckformen mit polaren Flexodruckfarben zu beobachten, wie es der Fachmann aufgrund der Erfahrungen mit wäßrig entwickelbaren Druckplatten erwartet hätte.

Im Gegenteil, das Druckverhalten lösungsmittelentwickelbarer Druckformen für den Flexodruck konnte durch den Zusatz der erfindungsgemäßen Verbindungen zur elastomeren Schicht c) erheblich verbessert werden.

In der elastomeren Schicht c) der erfindungsgemäßen photopolymerisierbaren Druckplatten sind 5 bis 30 % Epoxidharz-Kolophoniumharzumsetzungsprodukte, gemäß kennzeichnendem Teil des Ansprucks 1, bevorzugt 15 bis 25 Gew.% enthalten. Werden weniger als 5 Gew.% eingesetzt, ist keine wesentliche Verbesserung der Druckqualität zu beobachten, werden mehr als 30 Gew.% verwendet, so ist die Resistenz der Flexodruckformen gegenüber alkoholischen und wäßrigen Flexodruckfarben zu gering und dies führt zu Quellung der Druckoberfläche und damit zu Punktzuwachs. Als ungesättigte Mono- oder Polycarbonsäuren, die mit den Kolophoniumharzen Addukte bilden, können z.B. Acrylsäure, Methacrylsäure, Fumarsäure oder Maleinsäure oder auch deren Anhydride verwendet werden. Bevorzugt werden Acrylsäure und Maleinsäure verwendet. Die zur Veresterung dieser Addukte herangezogenen Polyole sind bevorzugt gesättigte Alkohole, besonders bevorzugt Pentaerythritol und Glycerin. Die für den letzten Reaktionsschritt zur Herstellung der erfindungswesentlichen Verbindungen benötigten Epoxidharze können fest oder flüssig sein. Ihr Epoxid-Äquivalentgewicht sollte zwischen 100 und 1 000 g, bevorzugt zwischen 150 und 400 g liegen.
Das Verhältnis von ungesättigtem, teilweise verestertem Kolophoniumharz Addukt zu Expoxidharz sollte 2:1 bis 1:2, bevorzugt 1,5:1 bis 1:1,5 insbesondere 1:1 betragen. Epoxid- und Kolophoniumharz können sowohl als Einzelkomponenten der Gießlösung der elastomeren Schicht zugesetzt und während des Herstellungs- prozesses miteinander umgesetzt werden, als auch als vorreagierte Mischung der Gießlösung zugesetzt werden.

Die elastomere Schicht c) enthält als Bindemittel 50 - 95 Gew.% mindestens eines thermoplastisch elastomeren Blockcopolymers, wie sie in der EP-B1 00 84 851 genannt werden. Das mittlere Molekulargewicht der Blockcopolymere sollte über 80 000, bevorzugt über 100 000, liegen. Bevorzugt werden Blockcopolymere mit 10 bis 30 Gew.%, bevorzugt 10 bis 25 Gew.%, Polystyrolendblöcken verwendet. Insbesondere 2-Block- und 3-Blockcopolymere mit Polystyrol- und Polybutadien- bzw. Polyisoprenblöcken werden bevorzugt. Vor allem radiale (Polystyrol-Polybutadien)₄-Si-Blockcopolymere mit einem Polystyrolgehalt von 10 bis 30 Gew. % können als Bindemittel eingesetzt werden.

Zusätzlich können in der elastomeren Schicht c) 0 bis 40 Gew.% weiterer Polymere, bevorzugt thermoplastischer Polymere, enthalten sein. Als Beispiele seien genannt Polymere und Copolymere aus Methylmethacrylat/Acrylnitril/ Butadien/Styrol, Styrol/Methylmethacrylat, Acrylnitril/Butadien/ Styrol, Butadien, Isopren, Chloropren, Styrol/Butadien, Styrol/Isopren oder Mischungen hieraus. Besonders geeignet sind thermoplastische Polymere mit einer Trübung (gemäß ASTM D 1003) von ≤ 20 %, bevorzugt ≤ 12 % und einer Rockwell Härte (gemäß ASTM D 785) von ≥ 50 bevorzugt ≥ 80.

Als weitere übliche Zusätze können Farbstoffe, Füllstoffe, Initiatoren, Weichmacher, Lösungsmittel, etc. verwendet werden wie sie in der EP-B1 00 84 851 genannt werden.

Die elastomere Schicht c) sollte eine Dicke von 0,01 bis 0,5 mm, bevorzugt 0,025 bis 0,12 mm, haben.

Die Schicht kann durch Gießen aus Lösungsmitteln wie Toluol, Methylethylketon, Aceton, Methylenchlorid, Perchlorethylen, etc. oder durch Extrusionsbeschichtung direkt auf die Deckfolie d), z.B. eine Polyethylenterephthalatfolie, oder auf eine auf der Deckfolie d) befindliche biegsame, polymere Folie e) aufgebracht werden. Wenn das thermoplastische Polymer nicht wie üblich gemeinsam mit anderen Komponenten zur Herstellung der Gießlösung für die elastomere Schicht c) in einem entsprechenden Lösungsmittel aufgelöst wird, sondern vorher separat im Lösungsmittel gelöst und diese Lösung vorfiltriert wird und dann diese Lösung zu einer Lösung der übrigen Gießkomponenten gegeben wird, so ist eine erhebliche Verbesserung der Gießqualität zu erzielen. Die 0,0025 mm bis 0,04 mm dicke polymere Folie e) ist im Entwicklerlösungsmittel für die photopolymerisierbare Schicht b) löslich oder zumindest mit diesem strippbar und besteht bevorzugt aus einem Polyamid, einem Copolymer aus Ethylen und Vinylacetat oder ähnlichen Polymeren.
Die erfindungswesentlichen Verbindungen können direkt der Gieß- bzw. Extrusionsmischung zur Herstellung der Schicht c) zugesetzt werden. Sie können aber auch nach dem Vergießen oder Extrudieren einer elastomeren Mischung, die die entsprechenden Mengen Ausgangsverbindungen der erfindungsgemäßen Verbindungen enthält durch thermische Behandlung einer solchen Schicht direkt in dieser Schicht hergestellt werden.

Die photopolymerisierbare Schicht b) der erfindungsgemäßen Druckplatten enthält mindestens ein elastomeres Bindemittel. Geeignet sind z.B. Blockcopolymere wie sie in DE-C3 22 15 090; US-A 4,320,188 und US-A 4,162,919 beschrieben werden. Bevorzugt werden Blockcopolymere vom A-B-A-Typ, die einen elastomeren Block, z.B. Polybutadien oder Polyisopren, zwischen zwei thermoplastischen Blöcken, z.B. Polystyrol, besitzen. Besonders bevorzugt werden lineare und radiale Blockcopolymere mit Polystyrol-Endblöcken verwendet, wie z.B. Polystyrol-Polyisopren-Polystyrol,, (Polystyrol-Polybutadien)₄-Si oder (Polystyrol-Polyisopren)₄-Si. Das mittlere Molekulargewicht der Blockcopolymere sollte zwischen 80 000 und 300 000 liegen, bevorzugt zwischen 100 000 und 250 000. Der Polystyrolanteil sollte 10 bis 40 Gew.% betragen, bevorzugt 15 bis 30 Gew.%.

Die photopolymerisierbare Schicht b) enthält außerdem mindestens ein durch aktinische Strahlung additionspolymerisierbares, ethylenisch ungesättigtes Monomer. Hierbei kann es sich sowohl um Monomere mit einer ethylenisch ungesättigten Gruppe als auch um solche mit mehreren ethylenisch ungesättigten Gruppen handeln. Die Monomere können allein oder auch in Kombination miteinander eingesetzt werden. Bevorzugt werden Monomermischungen aus einfach ungesättigten Acrylaten und/oder Methacrylaten und mehrfach ungesättigten Acrylaten und/oder Methacrylaten verwendet. Solche Monomermischungen werden z.B. in der DE-C1 37 44 243 beschrieben.

Als Beispiel seien genannt; Octylacrylat, Isodecylacrylat, Isodecylmethacrylat, 2-Hexyloxyethylacrylat, 1,4-Butandioldiacrylat, 1,6-Hexandioldiacrylat, 1,6-Hexandioldimethacrylat, Trimethylolpropantriacrylat.

Außerdem enthält die photopolymerisierbare Schicht b) einen Photoinitiator oder ein Photoinitiatorsystem, z.B.: α-Methylbenzoin, Benzophenon, Benzil-dimethyl-ketal oder Ethylanthrachinon/4,4'-Bis-(dimethylamino)-benzophenon. Ferner kann die photopolymerisierbare Schicht b) weitere Zusätze enthalten, wie z.B. Füllstoffe, Farbstoffe, Antioxidantien und Plastifizierungsmittel wie sie in EP-B1 00 84 851 genannt werden. Bevorzugt werden 0 - 30 Gew.% an Plastifizierungsmittel z.B. auf der Basis von Polystyrol bzw. Polybutadien und mit einem mittleren Molekulargewicht zwischen 1 000 und 10 000 verwendet.

Die photopolymerisierbare Schicht b) enthält allgemein 65 - 95 Gew.% Bindemittel, 5 - 30 Gew.% Monomer oder Monomermischung und 0,5 - 5 Gew.% Initiator.

Als Schichtträger a) eignen sich z.B. Aluminium, Stahl oder Kunststoffolien. Bevorzugt werden Polyesterfolien, die ggf. mit einer Haftschicht und/oder Antihaloschicht versehen sein können. Besonders geeignet sind Polyethylenterephthalatfolien.

Die erfindungsgemäßen, photopolymerisierbaren Druckplatten werden bevorzugt nach dem in der EP-B1 00 84 851 beschriebenen Verfahren hergestellt. Hierbei wird eine vorher extrudierte photopolymerisierbare Masse in den Spalt eines Kalanders eingeführt und zwischen einen Träger und ein Deckelement, bestehend aus einer Deckfolie d), ggf. einer biegsamen Folie e) und der erfindungsgemäßen Schicht c) kalandriert, wodurch eine photopolymerisierbare Schicht gebildet wird, die auf ihrer einen Seite an den Schichtträger und auf der anderen Seite an die elastomere Schicht c) des Deckelements angrenzt.

Die so hergestellte photopolymerisierbare Druckplatte wird abgekühlt und ggf. einer Vorbelichtung mit aktinischer Strahlung durch den Schichtträger hindurch unterworfen. Dann wird üblicherweise die Deckfolie entfernt, ein bildtragendes Transparent auf die photopolymerisierbare Druckplatte aufgelegt und durch dieses mit aktinischer Strahlung belichtet. Daraufhin wird die ggf. vorhandene biegsame, polymere Folie e) und die unbelichteten Bereiche der photopolymerisierbaren Schicht b) und der elastomeren Schicht c) durch Auswaschen mit einem Entwicklerlösungsmittel wie chlorierte Kohlenwasserstoffe, z.B. 1,1,1-Trichlorethan, oder gesättigte oder aromatische Kohlenwasserstoffe, die ggf. mit Alkoholen wie z.B. n-Butanol vermischt sein können entfernt werden. Bevorzugt werden die Lösungsmittel der deutschen Patentanmeldung P 38 28 551.7 verwendet. Zur Entwicklung kann das Lösungsmittel in beliebiger Weise aufgebracht werden, z.B. durch Gießen, Tauchen, Spritzen oder Walzenauftrag. Durch Bürsten wird die Entfernung der nicht vernetzten Schichtteile erleichtert. Nach dem Trocknen der so erhaltenen Druckformen bei 40 bis 75° C können diese in beliebiger Reihenfolge nachbelichtet und/oder zur Herstellung einer klebfreien Oberfläche z.B. mit einer freies Halogen enthaltenden Lösung behandelt werden.

Die in den folgende Beispielen angegebenen Prozente und Teile beziehen sich, soweit nicht anders angegeben, auf das Gewicht.

### Beispiel 1 (Vergleichsbeispiel)

| | |
|---|---|
| Polystyrol-Polyisopren-Polystyrol Blockcopolymer 15% Polystyrol, Brookfield Viskosität 1600 mPa s (25% in Toluol) | 67,4 % |
| Methylmethacrylat/Acrylnitril/Butadien/Styrol Tetrapolymer, 46/9/14/31 | 31,3 % |
| Acid Blue (C.I. 13390) | 1,3 % |

Zur Herstellung eines mehrschichtigen Deckelements wurden der Farbstoff und das Tetrapolymer bei 116° C zusammengeknetet und dann extrudiert und granuliert. Dieses Gemisch und die übrigen Inhaltsstoffe der elastomeren Schicht c) wurden dann zu einer 15%igen Lösung in Methylenchlorid verarbeitet. Diese Gießlösung wurde mittels eines Extrusionsschlitzgießers mit einer Spaltbreite von 0,38 mm auf die Polyamidbeschichtung einer Polyethylenterephthalatunterlage, wie in EP-B1 00 84 851 Beispiel 1 beschrieben, aufgetragen, getrocknet und mit einer siliconbeschichteten Polyethylenterephthalatschutzschicht versehen. Die Trockenschichtdicke betrug 0.051 mm. Zur Herstellung einer Flexodruckplatte wurde analog EP-B1 00 84 851, Beispiel 1, eine photopolymerisierbare Mischung aus 1,4 Teilen 2,2-Dimethoxy-2-phenylacetophenon, 5,3 Teilen Hexamethylenglykoldiacrylat, 3,7 Teilen Hexamethylenglykoldimethacrylat, 0,166 Teilen 2,6-Di-tert-butyl-p-kresol, 0,001 Teilen Hydrochinon, 0,003 Teilen roter Farbstoff (C.I. 109), 0,13 Teilen Hydroxyethylmethacrylat, 82,3 Teilen Polystyrol-Polyisopren-Polystyrol Blockcopolymer (15% Polystyrol, MG 150 000), 6 Teilen a-Methylstyrol/Vinyltoluol-Harz und 1 Teil mikrokristallines Kohlenwasserstoffwachs in einem Zweischneckenextruder hergestellt, extrudiert und zwischen eine Polyethylenterephthalatträgerschicht und die elastomere Schicht c) des o.g. Deckelements, nachdem die Polyethylenterephthalatschutzschicht entfernt war, kalandriert. Nach dem Abkühlen, der vollflächigen Rückseitenbelichtung durch die Trägerschicht und dem Entfernen der Polyethylenterephthalatdeckschicht wurde ein bildtragendes Transparent auf die Polyamidschicht aufgelegt und hierdurch die Druckplatte 6 Minuten mit aktinischer Strahlung belichtet. Die Entwicklung der photopolymerisierten Druckplatte erfolgte durch Auswaschen mit einem Tetrachlorethylen/n-Butanol Gemisch (75/25 Vol.%), wobei die Polyamidschicht und die unbelichteten Teile der photopolymerisierbaren Schicht b) und der elastomeren Schicht c) entfernt wurden. Anschließend wurde die Flexodruckform analog zu EP-B1 00 84 851 Beispiel 1 getrocknet, mit wäßriger Hypochloritlösung behandelt und nachbelichtet.

### Beispiel 2

### Zusammensetzung der elastomeren Schicht c)

| | |
|---|---|
| Polystyrol-Polyisopren-Polystyrol Blockcopolymer 15% Polystyrol, Brookfield Viskosität 1600 mPa s (25% ig in Toluol) | 53,2 % |
| Methylmethacrylat/Acrylnitril/Butadien/Styrol Tetrapolymer, 46/9/14/31 | 24,7 % |
| Acid Blue (C.I. 13390) | 1,1 % |
| Acrylsäure modifiziertes, mit Glycerin teilweise verestertes Kolophoniumharz (Säurezahl 220-250, Viskosität ca. 17 mPa s bei 20 °C, 50%ig in Ethanol) | 10,5 % |
| Bisphenol-A-Epichlorhydrin-Epoxidharz (Epoxid-Äquivalentgewicht 182-194 g, Viskosität 9-14 Pa s bei 25 °C nach ASTM D 445) | 10,5 % |

Eine 17%ige Lösung in Methylenchlorid wurde 24 Stunden bei Raumtemperatur gerührt und dann wie im Beispiel 1 zur elastomeren Schicht verarbeitet. Die Herstellung und die weitere Verarbeitung der Druckplatte erfolgte wie in Beispiel 1 beschrieben. Die Photoempfindlichkeit, der Belichtungsspielraum und das Entwicklungsverhalten entsprach der Druckplatte von Beispiel 1.

### Beispiel 3

### Zusammensetzung der elastomeren Schicht c)

| | |
|---|---|
| Radiales (Polystyrol-Polybutadien)₄-Si-Blockcopolymer 20% Polystyrol, Viskosität 19 mm²/s (5,23%ig in Toluol) | 51,2 % |
| Methylmethacrylat/Acrylnitril/Butadien/Styrol Tetrapolymer, 46/9/14/31, Trübung 10 % (ASTM 1003), Rockwell Härte 103 (ASTM 785) | 25,6 % |
| Ein in Didecylphthalat dispergiertes Cu-Phthalocyanin (C.I. 74160) | 1 % |
| Acrylsäure modifiziertes, mit Glycerin teilweise verestertes Kolophoniumharz (Säurezahl 220-250, Viskosität ca. 17 mPa s bei 20 °C, 50%ige in Ethanol) | 11,8 % |
| Bisphenol-A-Epichlorhydrin-Epoxidharz(Epoxid-Äquivalentgewicht 182-194 g, Viskosität 9-14 Pa s bei 25 °C nach ASTM D 445) | 10,4 % |

Das Tetrapolymer wurde in Toluol/Methylethylketon (4:1) aufgelöst und die Lösung filtriert. Aus dieser Lösung und den übrigen Komponenten wurd eine 17 %ige Gießlösung hergestellt. Die Herstellung der elastomeren Schicht und alle weiteren Verarbeitungsschritte erfolgten wie im Beispiel 1 beschrieben. Die Photoempfindlichkeit, der Belichtungsspielraum und das Entwicklungsverhalten entsprach der Druckplatte von Beispiel 1. Die Druckplatte zeichnete sich durch eine verbesserte Ozonstabilität aus.

### Beispiel 4

### Zusammensetzung der elastomeren Schicht c)

| | |
|---|---|
| Radiales (Polystyrol-Polybutadien)₄-Si-Blockcopolymer 20% Polystyrol, Viskosität 19 mm²/s (5,23%ige in Toluol) | 45 % |
| Methylmethacrylat/Acrylnitril/Butadien/Styrol Tetrapolymer, 46/9/14/31, Trübung 10 % (ASTM 1003), Rockwell Härte 103 (ASTM 785) | 22 % |
| Ein in Didecylphthalat dispergiertes Cu-Phthalocyanin (C.I. 74160) | 1 % |
| Acrylsäure modifiziertes, mit Glycerin teilweise verestertes Kolophoniumharz (Säurezahl 220-250, Viskosität ca. 17 mPa s bei 20 °C, 50%ig in Ethanol) | 13 % |
| Bisphenol-A-Epichlorhydrin-Epoxidharz (Epoxid-Äquivalentgewicht 182-194 g, Viskosität 9-14 Pa s bei 25 °C nach ASTM D 445) | 19 % |

Die Herstellung der Gießlösung und der elastomeren Schicht und alle weiteren Verarbeitungsschritte erfolgten wie in Beispiel 3. Die Photoempfindlichkeit, der Belichtungsspielraum und das Entwicklungsverhalten entsprach der Druckplatte von Beispiel 1. Die Druckplatte zeichnete sich durch eine verbesserte Ozonstabilität aus.

### Beispiel 5

### Zusammensetzung der elastomeren Schicht c)

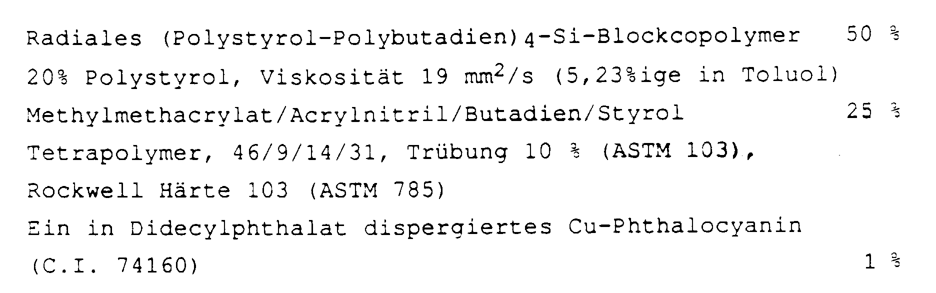

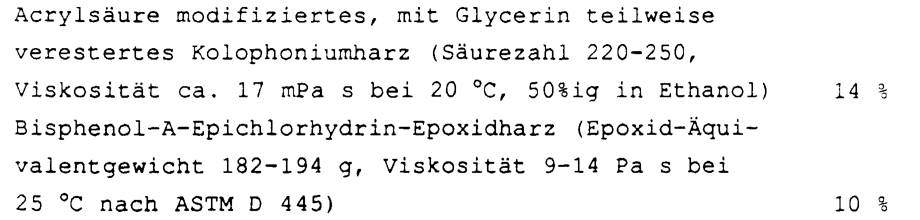

Ein Gemisch aus dem Kolophoniumharz und dem Epoxidharz wurde unter Rühren 2 h auf 175 °C erhitzt, wobei sich eine homogene Masse bildete, die in Toluol löslich ist. Diese Lösung und die übrigen Komponenten wurden dann zu einer 17%igen Lösung in Toluol/Methylethylketon (4:1) verarbeitet.Die Herstellung der elastomeren Schicht und alle weiteren Verarbeitungsschritte erfolgten wie in Beispiel 3. Die Photoempfindlichkeit, der Belichtungsspielraum und das Entwicklungsverhalten entsprach der Druckplatte von Beispiel 1. Die Druckplatte zeichnete sich durch eine verbesserte Ozonstabilität aus.

### Beispiel 6

### Zusammensetzung der elastomeren Schicht c)

| | |
|---|---|
| Radiales (Polystyrol-Polybutadien)₄-Si-Blockcopolymer 20% Polystyrol, Viskosität 19 mm²/s (5,23%ige in Toluol) | 53 % |
| Methylmethacrylat/Acrylnitril/Butadien/Styrol Tetrapolymer, 46/9/14/31, Trübung 10 % (ASTM 1003), Rockwell Härte 103 (ASTM 785) | 27 % |
| Ein in Didecylphthalat dispergiertes Cu-Phthalocyanin (C.I. 74160) | 1 % |
| Acrylsäure modifiziertes, mit Glycerin teilweise verestertes Kolophoniumharz (Säurezahl 220-250, Viskosität ca. 17 mPa s bei 20 °C, 50%ig in Ethanol) | 10 % |
| Bisphenol-A-Epichlorhydrin-Epoxidharz (Epoxid-Äquivalentgewicht 182-194 g; Viskosität 9-14 Pa s bei 25 °C nach ASTM D 445) | 9 % |

Die Herstellung der Gießlösung und der elastomeren Schicht und alle weiteren Verarbeitungsschritte erfolgten wie in Beispiel 3. Die Photoempfindlichkeit, der Belichtungsspielraum und das Entwicklungsverhalten entsprach der Druckplatte von Beispiel 1. Die Druckplatte zeichnete sich durch eine verbesserte Ozonstabilität aus.

### Drucktest

Die Druckversuche wurden auf einer weiß pigmentierten Polyethylenfolie mit einer alkoholischen Flexodruckfarbe (CYAN, Viskosität 29 mPa· sec/DIN 53211) durchgeführt, wobei eine Flexo-Druckmaschine mit einer Rasterwalze mit 170 Linien/cm and 5 g /m³ bei einer Druckgeschwindigkeit von 80 m/min verwendet wurde.

Die erfindungsgemäßen Druckplatten zeigen höhere Volltondichten und bessere Wiedergabe von Linien und Vollflächen als das Vergleichsmaterial.

## Patentansprüche

1. Photopolymerisierbare Druckplatte im wesentlichen bestehend aus
a) einem Schichtträger,
b) einer photopolymerisierbaren Schicht enthaltend mindestens ein elastomeres Bindemittel, mindestens ein durch aktinische Strahlung additionspolymerisierbares, ethylenisch ungesättigtes Monomer und einen Photoinitiator oder ein Photoinitiatorsystem,
c) einer elastomeren Schicht enthaltend mindestens ein thermoplastisch elastomeres Blockcopolymer
und
d) einer Deckfolie,
dadurch gekennzeichnet, daß
die elastomere Schicht c) außerdem mindestens ein Umsetzungsprodukt eines Epoxidharzes mit einem teilweise mit Polyolen veresterten Addukt von ungesättigten Mono- und/oder Polycarbonsäuren oder deren Anhydriden mit Kolophoniumharzen enthält.

2. Photopolymerisierbare Druckplatte nach Anspruch 1 dadurch gekennzeichnet, daß
die elastomere Schicht c) 5 bis 30 Gew.% des Epoxydharz-Kolophonium-harzumsetzungsproduktes enthält.

3. Photopolymerisierbare Druckplatte nach Anspruch 1 bis 2 dadurch gekennzeichnet, daß
die elastomere Schicht c) mindestens ein Umsetzungsprodukt eines Epoxidharzes mit einem mit Pentaerythritol und/oder Glycerin veresterten Addukt von Acrylsäure und/oder Methacrylsäure und/oder Fumarsäure und/oder Maleinsäure oder deren Anhydriden mit Kolophoniumharzen enthält.

4. Photopolymerisierbare Druckplatte nach Anspruch 1 bis 3 dadurch gekennzeichnet, daß
die elastomere Schicht c) 50 bis 95 Gew.% eines thermoplastisch elastomeren Blockcopolymers mit einem Polystyrolgehalt von 15 -30 Gew.% enthält.

5. Photopolymerisierbare Druckplatte nach Anspruch 1 bis 4 dadurch gekennzeichent, daß
die elastomere Schicht c) mindestens ein radiales (Polystyrol-Polybutadien)₄-Si-Blockcopolymer mit einem Polystyrolgehalt von 15 - 30 Gew.% enthält.

6. Photopolymerisierbare Druckplatte nach Anspruch 1 bis 5 dadurch gekennzeichnet, daß
die elastomere Schicht c) 0 bis 40 Gew.% eines thermoplastischen Polymers mit einer Trübung gemessen nach ASTM D 1003 von < 20 % und einer Rockwell Härte gemessen nach ASTM D 785 von ≥ 50 enthält.

7. Photopolymerisierbare Druckplatte nach Anspruch 1 bis 6 dadurch gekennzeichnet, daß
sie zwischen der elastomeren Schicht c) und der Deckfolie d) eine biegsame polymere Folie e) enthält.

8. Verfahren zur Herstellung der elastomeren Schicht c) einer photopolymeren Druckplatte gemäß Anspruch 6, dadurch gekennzeichnet, daß
das thermoplastische Polymer, im Lösungsmittel für die Gießlösung aufgelöst und diese Lösung filtriert wird und dann aus den übrigen Komponenten und der so vorbehandelten Lösung des Polymeren die Gießlösung für die elastomere Schicht c) hergestellt wird.

9. Verfahren zur Herstellung photopolymerisierbarer Druckplatten, bei dem in den Spalt eines Kalanders eine photopolymerisierbare Masse aus mindestens einem elastomeren Bindemittel, mindestens einem durch aktinische Strahlung additionspolymerisierbaren, ethylenisch ungesättigten Monomer und einem Photoinitiator oder einem Photoinitiatorsystem eingeführt und zwischen einem Träger a) und ein mehrschichtiges Deckelement kalandriert wird und die photopolymerisierbare Schicht b) zwischen ihnen gebildet wird, wobei das mehrschichtige Deckelement im wesentlichen aus einer elastomeren Schicht c) enthaltend mindestens ein thermoplastisch elastomeres Blockcopolymer, und einer Deckfolie d) besteht
dadurch gekennzeichnet, daß
die elastomere Schicht c) mindestens ein Umsetzungsprodukt eines Epoxidharzes mit einem teilweise mit Polyolen veresterten Addukt von ungesättigten Mono- und/oder Polycarbonsäuren oder deren Anhydriden mit Kolophoniumharzen enthält.

10. Verfahren zur Herstellung von flexographischen Druckformen umfassend
1) das bildmäßige Belichten mit aktinischer Strahlung einer photopolymerisierbaren Druckplatte gemäß Anspruch 1 bis 7
a) durch die Deckfolie d) oder
b) nach Entfernen der Deckfolie d) durch die elastomere Schicht c) oder
c) nach Entfernen der Deckfolie d) durch eine biegsame polymere Folie e), falls diese in der photopolymerisierbaren Druckplatte zwischen elastomerer Schicht c) und Deckfolie d) vorhanden ist, und
2) das Entfernen der biegsamen, polymere Folie e), falls vorhanden, und der unbelichteten Bereiche der photopolymerisierbaren Schicht b) und der elastomeren Schicht c) durch Auswaschen mit Entwicklerlösungsmitteln.

## Claims

1. Photopolymerizable printing plate consisting essentially of
a) a support,
b) a photopolymerizable layer containing at least one elastomeric binder, at least one ethylenically unsaturated monomer addition-polymerizable by actinic radiation, and a photoinitiator or a photoinintiator system,
c) an elastomeric layer containing at least one thermoplastic, elastomeric block copolymer, and
d) a cover sheet,
characterized in that,
the elastomeric layer c) further comprises at least one reaction product of an epoxide resin with an adduct, partially esterified with polyols, of unsaturated monocarboxylic and/or polycarboxylic acids or their anhydrides with rosins.

2. Photopolymerizable printing plate according to claim 1 characterized in that,
the elastomeric layer c) comprises 5 to 30 percent by weight of the epoxide resin /rosin reaction product.

3. Photopolymerizable printing plate according to claim 1 to 2 characterized in that,
the elastomeric layer c) comprises at least one reaction product of an epoxide resin with an adduct, esterified with pentaerythritol and/or glycerin, of acrylic acid and/or methacrylic acid and/or fumaric acid and/or maleic acid or their anhydrides with rosins.

4. Photopolymerizable printing plate according to claim 1 to 3 characterized in that,
the elastomeric layer c) comprises 50 to 95 percent by weight of a thermoplastic, elastomeric block copolymer with 15-30 percent by weight polystyrene content.

5. Photopolymerizable printing plate according to claim 1 to 4 characterized in that,
the elastomeric layer c) comprises at least one radial (polystyrene/polybutadiene)₄Si block copolymer with 15-30 percent by weight polystyrene content.

6. Photopolymerizable printing plate according to claim 1 to 5 characterized in that,
the elastomeric layer c) comprises 0 to 40 percent by weight of a thermoplastic polymer having a turbidity according to ASTM D 1003 of ≤ 20 % and a Rockwell hardness according to ASTM D 785 of ≥ 50.

7. Photopolymerizable printing plate according to claim 1 to 6 characterized in that,
a flexible polymeric film e) is interposed between the elastomeric layer c) and the cover sheet d).

8. Process for the preparation of the elastomeric layer c) of a photopolymerizable printing plate according to claim 6 characterized in that
the thermoplastic polymer is dissolved in the solvent of the coating solution and this solution is filtered and then the coating solution is prepared of the remaining components and the so pretreated solution of the polymer.

9. Process for the preparation of a photopolymerizable printing plate wherein a photopolymerizable composition comprising at least one elastomeric binder, at least one ethylenically unsaturated monomer additionally polymerizable by actinic radiation, and a photoinitiator or a photoinitiator system, is feed into the nip of a calender and calendered between a support a) and a multilayer cover element consisting essentially of an elastomeric layer c) comprising at least one thermoplastic, elastomeric block copolymer, and a cover sheet d), whereby the photopolymerizable layer b) is formed between these layers, characterized in that,
the elastomeric layer c) comprises at least one reaction product of an epoxide resin with an adduct, partially esterified with polyols, of unsaturated monocarboxylic and/or polycarboxylic acids or their anhydrides with rosins.

10. Process for the preparation of flexographic printing forms comprising
1) imagewise exposure with actinic radiation of a photopolymerizable printing plate according to claim 1 to 7
a) through the cover sheet d) or
b) after removal of the cover sheet d) through the elastomeric layer c) or
c) after removal of the cover sheet d) through a flexible polymeric film e), provided said sheet is present on the photopolymerizable printing plate between the elastomeric layer c) and the cover sheet d), and
2) remove of the flexible polymeric sheet e), if present, and of the unexposed areas of the photopolymerizable layer b) and of the elastomeric layer c) by wash off with developer solvents.

## Revendications

1. Plaque d'impression photopolymérisable essentiellement constituée:
a) d'une couche porteuse:
b) d'une couche photopolymérisable contenant au moins un liant élastomère, au moins un monomère insaturé éthyléniquement, polymérisable par addition sous l'influence d'une irradiation actinique et un photoinitiateur ou un système photoinitiateur,
c) une couche d'élastomère contenant au moins un copolymère séquencé élastomère thermoplastique et
d) une couche de protection,
caractérisée en ce que la couche élastomère c) contient au moins un produit de réaction d'une résine époxyde avec un produit d'addition partiellement estérifié par des polyols, d'acides mono et/ou polycarboxyliques insaturés et/ou de leurs anhydrides avec une résine de colophane.

2. Plaque d'impression photopolymérisable selon la revendication 1, caractérisée en ce que la couche élastomère c) contient de 5 à 30% en poids de produit de réaction de résine époxyde-résine de colophane.

3. Plaque d'impression photopolymérisable selon la revendication 1 ou 2, caractérisée en ce que la couche élastomère c) contient au moins un produit de réaction d'une résine époxyde avec un produit d'addition, estérifié à l'aide de pentaérythritol et/ou de glycérine, d'acide acrylique et/ou d'acide méthacrylique et/ou d'acide fumarique et/ou d'acide maléique ou de leurs anhydrides avec des résines de colophane.

4. Plaque d'impression photopolymérisable selon les revendications 1 à 3, caractérisée en ce que la couche élastomère c) contient de 50 à 95% en poids d'un copolymère-séquencé élastomère thermoplastique présentant une teneur en polystyrène de 15 à 30% en poids.

5. Plaque d'impression photopolymérisable selon les revendications 1 à 4, caractérisée en ce que la couche élastomère c) contient au moins un copolymère séquencé (polystyrène-polybutadiène)₄-Si présentant une teneur en polystyrène de 15 à 30% en poids.

6. Plaque d'impression photopolymérisable selon les revendications 1 à 5, caractérisée en ce que la couche élastomère c) contient de 0 à 40% en poids d'un polymère thermoplastique ayant un trouble, mesuré suivant la norme ASTM D 1003, ≤ 20% et une dureté Rockwell, mesurée selon la norme ASTM D 785, ≥ 50.

7. Plaque d'impression photopolymérisable selon les revendications 1 à 6, caractérisée en ce qu'elle contient, entre la couche élastomère c) et la couche de protection d), un film de polymère flexible e).

8. Procédé de préparation de la couche élastomère c) d'une plaque d'impression photopolymérisable selon la revendication 6, caractérisé en ce que le polymère thermoplastique est mis en solution dans un solvant pour la solution de coulée et cette solution est filtrée et ensuite, à partir des autres composants et de la solution ainsi pré-traitée du polymère, la solution de coulée est fabriquée pour la couche élastomère c).

9. Procédé de préparation de plaque d'impression,photopolymérisable dans lequel on introduit, dans l'écartement existant entre les cylindres d'une calandre, une masse photopolymérisable d'au moins un liant élastomère, d'au moins un monomère insaturé éthyléniquement polymérisable par addition sous l'influence d'une radiation actinique et d'un photoinitiateur ou d'un système photoinitiateur et on la stratifie entre un support a) et un élément de protection à plusieurs couches et on forme la couche photopolymérisable b) entre elles, l'élément de protection à plusieurs couches étant essentiellement constitué d'une couche élastomère c) contenant au moins un copolymère séquencé thermoplastique élastomère et un film de protection d), caractérisé en ce que la couche élastomère c) contient au moins un produit de réaction d'une résine époxyde avec un produit d'addition partiellement estérifié par des polyols, d'acides monocarboxyliques ou d'acides polycarboxyliques insaturés ou leurs anhydrides avec des résines de colophane.

10. Procédé de préparation de plaques d'impressions flexographiques comprenant:
1) l'exposition suivant une image à une radiation actinique d'un cliché photopolymérisable suivant les revendications 1 à 7,
a) à travers la couche protectrice d) ou
b) après détachement de la couche de protection d), à travers la couche élastomère, ou
c) après élimination de la couche protectrice d), à travers un film de polymère e) flexible, au cas où cette dernière est présente dans la plaque d'impression entre la couche élastomère c) et la couche de protection d), et
2) élimination du film polymère d) flexible dans le cas où il est présent, et des régions non exposées de la couche photopolymérisable b) et de la couche élastomère c) par lavage à l'aide de solvants de développement.
